# EUROPEAN PATENT APPLICATION

(11) **EP 4 823 273 A1**
(43) Date of publication of application: **14.10.2026**
(21) Application number: 25209704.3
(22) Date of filing: 20.10.2025
(51) Int. Cl.: H10D 30/01, H10D 30/47, H10D 62/17, H10D 64/27, H10D 64/60, H10D 62/85, H10D 64/64

(54) **HEMT COMPRISING PITS IN THE GATE STACK AND METHOD FOR MANUFACTURING THEREOF**

(30) Priority: 09.04.2025 CN 202510440009
(71) Applicant: Enkris Semiconductor, Inc, Suzhou, Jiangsu 215125 (CN)
(72) Inventor: CHENG, Kai, Suzhou, 215125 (CN)
(74) Representative: Dai, Simin

(57) **Abstract**

The present disclosure provides a semiconductor structure, in particular a HEMT, and a method for manufacturing thereof, and the semiconductor structure includes a substrate (10), a III-Nitride channel layer (20) on the substrate and a barrier layer (30) on the channel layer; a P-type III-Nitride layer (40) in a gate region and on a side of the barrier layer away from the substrate; and a cap layer (50) on a side of the P-type III-Nitride layer away from the substrate; where a surface of the cap layer away from the substrate includes pits (51) which can change crystal planes from the C-crystal plane to the non-C crystal plane of the contact interface between the cap layer and a Schottky gate electrode (63).

## Description

### TECHNICAL FIELD

The present disclosure relates to the technical field of semiconductors, in particular to a semiconductor structure and a method for manufacturing thereof.

### BACKGROUND

Compared with the first generation semiconductor materials and the second generation semiconductor materials, the third generation semiconductor materials, especially GaN-based materials, exhibit advantages, such as wide bandgap, high breakdown electric field, high electron mobility, and strong radiation resistance; and GaN-based HEMT (High Electron Mobility Transistor) devices demonstrate significant development potential in high-frequency and high-power applications, such as wireless communication base stations, radar, automotive electronics, and so on.

GaN-based HEMT devices are typically depletion-mode field-effect transistors, but in practical applications, enhancement-mode HEMT devices are often required due to cost considerations and fault protection requirements. Conventional GaN-based HEMT devices can achieve the enhancement-mode devices using P-type gate, but processes of forming the P-type gate still face issues such as current leakage.

### SUMMARY

In view of this, according to the present disclosure, a semiconductor structure and a method for manufacturing thereof are provided.

According to one aspect of the present disclosure, an embodiment of the present disclosure provides a semiconductor structure, including:
a substrate, a channel layer on the substrate and a barrier layer on the channel layer;
a P-type layer in a gate region and on a side of the barrier layer away from the substrate; and
a cap layer on a side of the P-type layer away from the substrate;
where a surface of the cap layer away from the substrate includes pits, and crystal planes of inner walls of the pits include (1101) or (1122) crystal planes.

In some embodiments, the pits include V-shaped pits formed by epitaxial growth, or pyramid-shaped pits or frustum-shaped pits formed by etching.

In some embodiments, the semiconductor structure further includes: an insertion layer between the P-type layer and the cap layer.

In some embodiments, the cap layer is made of InGaN, AlInGaN, unintentionally doped GaN or n-type doped GaN.

In some embodiments, a ratio of a total projected area of the pits on a plane of the substrate to a projected area of the cap layer on the plane of the substrate is greater than 70%.

In some embodiments, a depth of at least one of the pits is different from depths of other pits.

In some embodiments, depths of the pits gradually increase from a center to an edge.

In some embodiments, a projection density of the pits on a plane of the substrate gradually increases from a center to an edge.

In some embodiments, the semiconductor includes a source electrode and a drain electrode on the side of the barrier layer away from the substrate; and
a gate electrode on a side of the cap layer away from the substrate and between the source electrode and the drain electrode.

In some embodiments, the pits are completely filled with a metal material of the gate electrode.

According to another aspect of the present disclosure, an embodiment of the present disclosure provides a method for manufacturing a semiconductor structure, including:
S1, providing a substrate, a channel layer and a barrier layer which are sequentially stacked; and
S2, forming a P-type layer and a cap layer which are in a gate region and sequentially stacked on a side of the barrier layer away from the substrate, where a surface of the cap layer away from the substrate includes pits, and crystal planes of inner walls of the pits include (1101) or (1122) crystal planes.

In some embodiments, forming the P-type layer and the cap layer which are in the gate region and sequentially stacked on the side of the barrier layer away from the substrate includes:
growing a blanket P-type layer and a blanket cap layer sequentially; and
removing a part of the blanket P-type layer and a part of the blanket cap layer outside the gate region by etching.

In some embodiments, forming the P-type layer and the cap layer which are in the gate region and sequentially stacked on the side of the barrier layer away from the substrate includes: growing a blanket P-type layer; removing a part of the blanket P-type layer outside the gate region by etching to obtain the P-type layer; and forming the cap layer on the P-type layer in the gate region by selective epitaxy.

In some embodiments, the pits include:
V-shaped pits formed when the cap layer is epitaxially grown, where crystal planes of inner walls of the V-shaped pits include (1101) crystal planes; or pyramid-shaped pits or frustum-shaped pits formed when the cap layer is etched, where crystal planes of inner walls of the pyramid-shaped pits or the frustum-shaped pits include (1101) or (1122) crystal planes.

In some embodiments, the method for manufacturing the semiconductor structure further includes:
S3, providing a source electrode and a drain electrode on the side of the barrier layer away from the substrate, and providing a gate electrode on the side of the cap layer away from the substrate and between the source electrode and the drain electrode.

In some embodiments, the pits are completely filled with a metal material of the gate electrode.

### BRIEF DESCRIPTION OF DRAWINGS

FIG. 1 is a schematic structural diagram of a semiconductor structure according to some embodiments of the present disclosure.
FIG. 2a is a schematic structural diagram of a semiconductor structure according to some embodiments of the present disclosure.
FIG. 2b is a top view schematic diagram of a cap layer of the semiconductor structure provided in FIG. 2a.
FIG. 3a is a schematic structural diagram of a semiconductor structure according to some embodiments of the present disclosure.
FIG. 3b is a top view schematic diagram of a cap layer of the semiconductor structure provided in FIG. 3a.
FIG. 4 is a schematic structural diagram of a semiconductor structure according to some embodiments of the present disclosure.
FIG. 5 is a flowchart of a method for manufacturing a semiconductor structure according to some embodiments of the present disclosure.
FIGs. 6 to 11 are schematic diagrams of intermediate structures of a semiconductor structure in a manufacturing process according to some embodiments of the present disclosure.
FIG. 12 is a schematic three-dimensional structural diagram of a cap layer of a semiconductor structure according to some embodiments of the present disclosure.

### DETAILED DESCRIPTION

The technical solutions in the embodiments of the present disclosure will be clearly and completely described below with reference to the accompanying drawings in the embodiments of the present disclosure, and obviously, the described embodiments are only some but not all of the embodiments of the present disclosure. All other embodiments obtained by a person of ordinary skill in the art based on the embodiments of the present disclosure without creative efforts shall fall within the protection scope of the present disclosure.

To reduce the gate leakage current of the P-type gate HEMT device and improve the quality of the P-type gate HEMT device, the present disclosure provides a semiconductor structure and a method for manufacturing thereof, and the semiconductor structure includes a substrate, a channel layer on the substrate and a barrier layer on the channel layer; a P-type layer in the gate region and on a side of the barrier layer away from the substrate; and a cap layer on a side of the P-type layer away from the substrate, where a surface of the cap layer away from the substrate includes pits. According to the present disclosure, the pits provided in the cap layer can replace the crystal planes of the contact interface between the cap layer and the gate electrode from the C crystal plane to the non-C crystal plane, thereby effectively improving the Schottky barrier height, reducing the gate leakage current, and improving the quality and the reliability of the device.

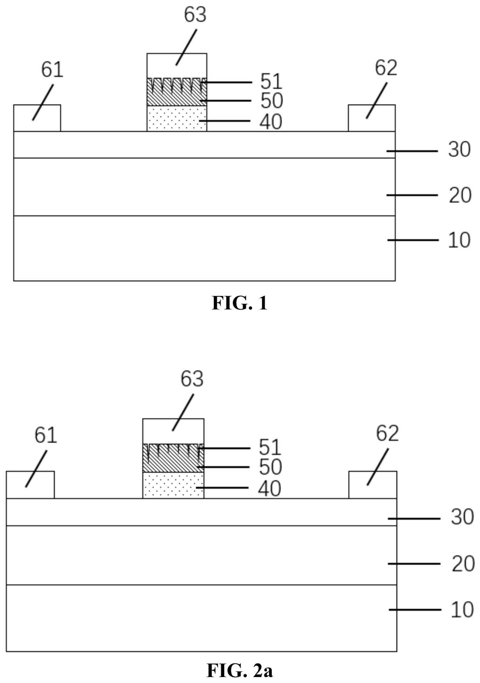

A semiconductor structure and a manufacturing method thereof mentioned in the present disclosure are further illustrated below with reference to FIGs. 1 to 11.

FIG. 1 is a schematic structural diagram of a semiconductor structure according to some embodiments of the present disclosure. As shown in FIG. 1, the semiconductor structure includes: a substrate 10, a channel layer 20, and a barrier layer 30 which are sequentially stacked; a P-type layer 40 in a gate region and on a side of the barrier layer 30 away from the substrate 10; and a cap layer 50 on a side of the P-type layer 40 away from the substrate 10, where a surface of the cap layer 50 away from the substrate 10 includes pits 51, and crystal planes of inner walls of the pits 51 include (11̅01) or (112̅2) crystal planes. When the crystal plane of the contact interface between the cap layer 50 and the gate electrode is a C crystal plane, the C crystal plane exhibits a lower Schottky barrier height compared to non-C crystal planes (such as (11̅01) or (112̅2) crystal planes). According to the present disclosure, the pits 51 provided in the cap layer 50 can replace the C crystal planes by the non-C crystal planes at the contact interface between the cap layer 50 and the gate electrode, thereby effectively increasing the Schottky barrier height, reducing the gate leakage current, and improving the quality and the reliability of the device.

In this embodiment, as shown in FIG. 1, the semiconductor structure further includes:
a source electrode 61 and a drain electrode 62 on the side of the barrier layer 30 away from the substrate 10, and a gate electrode 63 on the side of the cap layer 50 away from the substrate 10 and between the source electrode 61 and the drain electrode 62. The pits 51 are completely filled with a metal material of the gate electrode 63. By providing the pits including the inner walls with the (11̅01) or (112̅2) crystal planes in the surface of the cap layer toward the gate electrode, the contact interface between the cap layer 50 and the gate electrode 63 is replaced from the C crystal planes to the (11̅01) or (112̅2) crystal planes. The C crystal plane typically exhibits higher surface state density, leading to a stronger Fermi-level pinning effect. When the metal is in contact with the semiconductor, this effect restricts the Schottky barrier height within a narrow range, thereby making it difficult to improve. Additionally, the C crystal plane has the specific polarization direction and intensity, and when the C crystal plane contacts the metal gate electrode, the polarization effect influence the electric field distribution and the charge accumulation at the interface. These effects can reduce the Schottky barrier height. However, the (11̅01) or (112̅2) crystal planes are non-C crystal planes, and exhibit relatively lower surface state density and weaker Fermi-level pinning effect. When metal gate electrode contacts these crystal planes, factors such as the metal's work function and the semiconductor's electron affinity can more fully effect, thereby making the Schottky barrier height closer to the ideal value determined by the intrinsic properties of the metal and semiconductor materials, to achieve a higher barrier height. Additionally, the polarization properties of the (11̅01) or (112̅2) crystal planes differ from those of the C crystal planes, and the polarization direction and strength of the (11̅01) or (112̅2) crystal planes are more conducive for forming an enhanced built-in electric field at the interface. When metal contacts these crystal planes, the resulting electric field distribution becomes more favorable for increasing the barrier height, which results in that the electrons need to overcome higher energy to transition from the semiconductor side to the metal side, thereby effectively raising the Schottky barrier height, reducing the gate leakage current, and enhancing the quality and the reliability of the device. Moreover, the gate control capability is improved.

In this embodiment, the substrate 10 may be made of sapphire, silicon carbide, silicon, GaN or diamond. Materials of the channel layer 20 and the barrier layer 30 may include Group III nitrides, and a two-dimensional electron gas may be formed at an interface of the channel layer 20 and the barrier layer 30.

In some embodiments, the channel layer 20 is a GaN layer and the barrier layer 30 is an AlGaN layer. In other embodiments, the material combination of the channel layer 20 and the potential barrier layer 30 may also be GaN/AIN, GaN/InN, GaN/InAlGaN, GaN/InAlN, or InN/InAlN. The material of the P-type layer 40 includes a P-type doped GaN-based material.

In this embodiment, the material of the cap layer 50 includes InGaN, AlInGaN, unintentionally doped GaN or n-type doped GaN. When the cap layer 50 is made of InGaN or AlInGaN, V-shaped pits may be generated during the epitaxial growth of the InGaN or AlInGaN, so that the pits 51 are V-shaped pits formed by epitaxial growth, and crystal planes of inner walls of the pits 51 include (11̅01) crystal planes; when the cap layer 50 is made of unintentionally doped GaN or n-type doped GaN, the pits 51 may be pyramid-shaped pits or frustum-shaped pits formed by etching, and crystal planes of inner walls of the pits 51 include (11̅01) or (112̅2) crystal planes. Specifically, the principle of forming the pits 51 may refer to the embodiment of the manufacturing method, which will not be repeated herein. The pits 51 provided in the cap layer 50 can replace the contact interface between the cap layer 50 and the gate electrode 63 from the C crystal plane to the (11̅01) or (112̅2) crystal planes, thereby effectively improving the Schottky barrier height, reducing the gate leakage current, and improving the quality and the reliability of the device.

In some embodiments, a ratio of a total projected area of the pits 51 on a plane of the substrate 10 to a projected area of the cap layer 50 on the plane of the substrate 10 is greater than 70%. The density and the size of the pits 51 are increased, that is, the area of the C crystal plane in the cap layer 50 in contact with the metal of the gate electrode is reduced, thereby improving the Schottky barrier height, reducing the gate leakage current, and improving the quality and the reliability of the device.

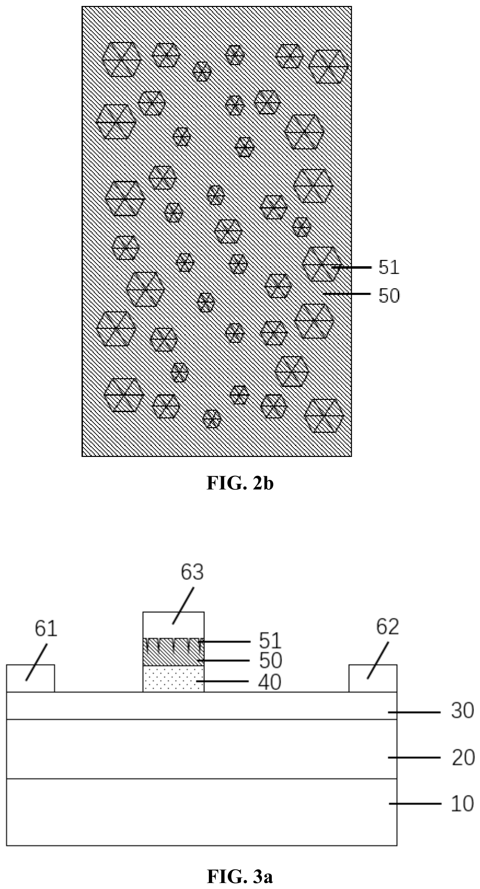

In some embodiments, FIG. 2a is a schematic structural diagram of a semiconductor structure according to some embodiments of the present disclosure, and FIG. 2b is a top view schematic diagram of a cap layer of the semiconductor structure provided in FIG. 2a. As shown in FIGs. 2a and 2b, a depth of at least one of the pits is different from depths of other pits. It can be understood that when the crystal plane of the pit is determined, the larger the depth of the pit, the larger the area of the orthographic projection of this pit on the substrate.

In some examples, as shown in FIGs. 2a and 2b, depths of the pits 51 gradually increase from a center to an edge, the center refers to a region of the cap layer 50 away from the sidewall of the cap layer 50, and the edge refers to a region of the cap layer 50 close to the sidewall of the cap layer 50. The current leakage issues are more prone to occur at the sidewall of the gate region in semiconductor structures. Therefore, the depths of the pits 51 at the edge are designed to be larger, thereby reducing the possibility of sidewall leakage. In some examples, as shown in FIG. 2b, the areas of the orthographic projections of the pits 51 on the substrate 10 gradually increases from the center to the edge, and compared with the pits 51 in the center of the cap layer 50, the pits 51 in the edge region of the cap layer 50 is larger, thereby further reducing the area of the C crystal plane of the cap layer 50 in contact with the metal of the gate electrode at the edge region of the cap layer 50, reducing the leakage current at the sidewall of the gate electrode, and improving the quality and the reliability of the device. Generally, the direction from the center to the edge is parallel to the direction from the source electrode to the drain electrode. In some examples, the depth of the pits in the edge region of the cap layer close to the drain electrode is greater than the depth of the pits in the edge region of the cap layer close to the source electrode, which can reduce the area of the C crystal plane in the edge region of the cap layer close to the drain electrode and in contact with the metal of the gate electrode, and reduce the current leakage caused by the increased reverse current at the drain side.

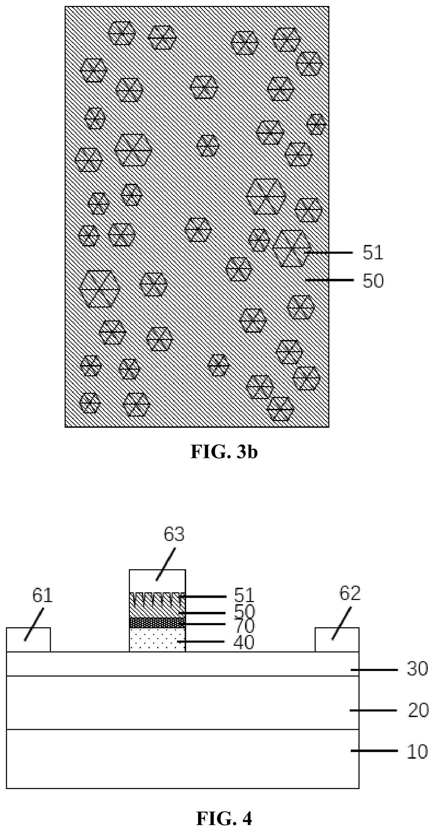

In some embodiments, FIG. 3a is a schematic structural diagram of a semiconductor structure according to some embodiments of the present disclosure, and FIG. 3b is a top view schematic diagram of a cap layer of the semiconductor structure provided in FIG. 3a. As shown in FIGs. 3a and 3b, the projection density of the pits 51 on the plane of the substrate 10 gradually increases from the center to the edge. The current leakage issues are more prone to occur at the sidewall of the gate region in semiconductor structures. Therefore, the density of the pits 51 at the edge are designed to be larger, thereby reducing the possibility of sidewall leakage.

It should be noted that, as shown in FIGs. 2b and 3b, a top view shape of the pit 51 is a hexagon, and a three-dimensional structure of the pit 51 is a hexagonal pyramid.

In some examples, the pits 51 penetrate through the cap layer 50, and within a thickness range of the cap layer 50, the three-dimensional structure of the pit 51 is a hexagonal frustum.

In an embodiment, FIG. 4 is a schematic cross-sectional structural diagram of a semiconductor structure according to some embodiments of the present disclosure, and as shown in FIG. 4, the semiconductor structure further includes an insertion layer 70 between the P-type layer 40 and the cap layer 50. In some examples, the bandgap of the insertion layer 70 is greater than the bandgap of the cap layer 50. Specifically, by introducing the insertion layer 70, a higher barrier can be formed, which effectively limits the diffusion of electrons or holes under the gate electrode, reduces leakage and improves the stability of the threshold voltage. In some examples, when the insertion layer 70 contains an Al element, the insertion layer 70 can serve as an etch stop layer during the etching process of forming the pits, thereby preventing the etching process from affecting the underlying P-type layer 40.

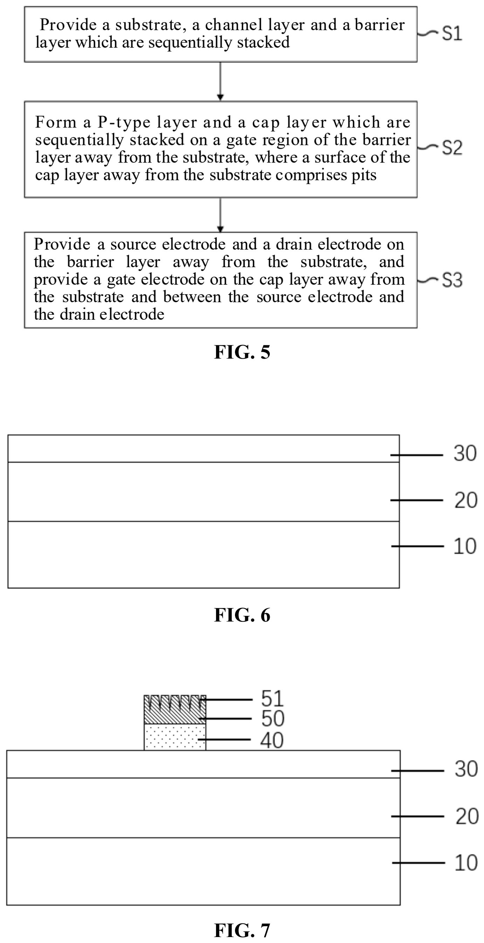

According to another aspect of the present disclosure, the present disclosure provides a method for manufacturing a semiconductor structure. FIG. 5 is a flowchart of a method for manufacturing a semiconductor structure according to some embodiments of the present disclosure, and FIGs. 6 to 11 are schematic diagrams of intermediate structures of a semiconductor structure in a manufacturing process according to some embodiments of the present disclosure. As shown in FIG. 5, a method for manufacturing a semiconductor structure according to an embodiment of the present disclosure includes the following steps S1-S3.

S1, a substrate, a channel layer and a barrier layer which are sequentially stacked are provided.

Specifically, as shown in FIG. 6, the substrate 10, the channel layer 20 and the barrier layer 30 are sequentially stacked. The substrate 10 may be made of sapphire, silicon carbide, silicon, GaN, or diamond. Materials of the channel layer 20 and the barrier layer 30 may include Group III nitrides, and a two-dimensional electron gas may be formed at an interface of the channel layer 20 and the barrier layer 30. In some embodiments, the channel layer 20 is a GaN layer and the barrier layer 30 is an AlGaN layer. In other embodiments, the material combination of the channel layer 20 and the potential barrier layer 30 may also be GaN/AIN, GaN/InN, GaN/InAlGaN, GaAs/AlGaAs, GaN/InAlN, or InN/InAlN.

At step S2, a P-type layer and a cap layer which are in a gate region and sequentially stacked on a side of the barrier layer away from the substrate are formed, where a surface of the cap layer away from the substrate includes pits.

Specifically, as shown in FIG. 7, the P-type layer 40 and the cap layer 50 which are in a gate region and sequentially stacked on the side of the barrier layer 30 away from the substrate 10 are formed, where the surface of the cap layer 50 away from the substrate 10 includes the pits 51. The material of the P-type layer 40 includes a P-type doped GaN-based material. The cap layer is made of InGaN, AlInGaN, unintentionally doped GaN or n-type doped GaN. When the cap layer 50 is made of InGaN or AlInGaN, V-shaped pits may be generated during the epitaxial growth of the InGaN or AlInGaN, so that the pits 51 are V-shaped pit defects formed by epitaxial growth, and crystal planes of inner walls of the pits 51 include (1101) crystal planes; when the cap layer 50 is made of unintentionally doped GaN or n-type doped GaN, the pits 51 may be pyramid-shaped pits or frustum-shaped pit formed by etching, and crystal planes of inner walls of the pits 51 include (1101) or (1122) crystal planes. Specifically, when the cap layer 50 is made of InGaN or AlInGaN, during the epitaxial growth of the InGaN or AlInGaN, if the material thickness exceeds the critical thickness, the material surface will form V-shaped pits to relieve strain, thereby forming the V-shaped pits 51. Alternatively, the cap layer 50 includes the Si/Mg co-doped material. Specifically, when the cap layer 50 is made of the unintentionally doped GaN or the n-type doped GaN, the SiH₄ treatment may be performed on the surface of the material, and selective etching may be performed around the dislocation using SiH₄, to form the pyramid-shaped or frustum-shaped pits 51. The SiH₄ treatment can be performed on the surface of the blanket cap layer 50, and then a part of the cap layer 50 out of the gate region are removed by etching; or the SiH₄ treatment can be performed locally on the surface of the cap layer 50 in the gate region after etching to remove the part of the cap layer 50 outside the gate region.

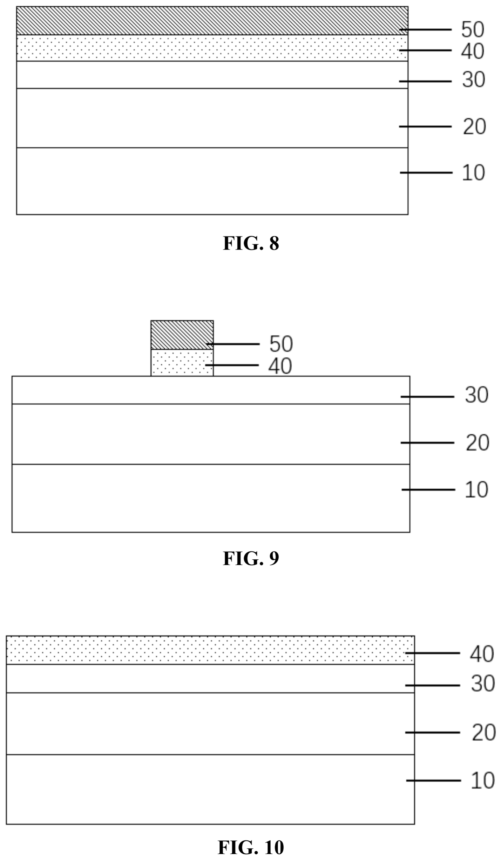

In some embodiments, the step of forming the P-type layer 40 and the cap layer 50 which are sequentially stacked on the gate region includes: as shown in FIG. 8, growing a blanket P-type layer 40 and a blanket cap layer 50 sequentially; and as shown in FIG. 9, removing a part of the blanket P-type layer 40 and a part of the blanket cap layer 50 outside the gate region by etching.

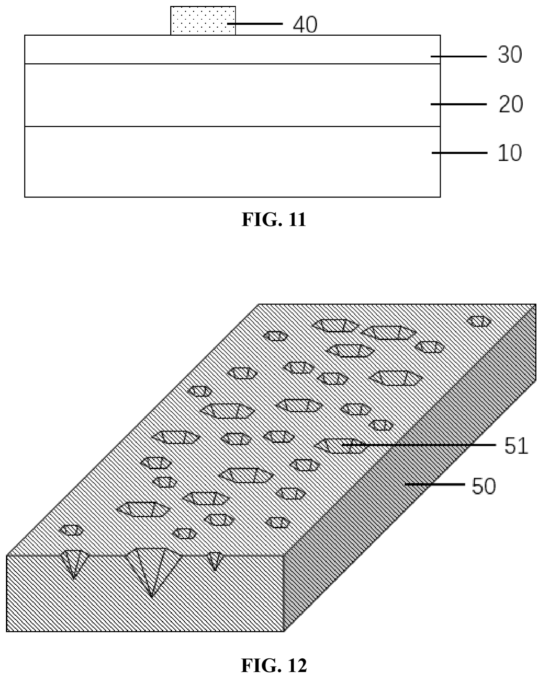

In some embodiments, the step of forming the P-type layer 40 and the cap layer 50 which are sequentially stacked on the gate region includes: as shown in FIG. 10, growing a blanket P-type layer 40, as shown in FIG. 11, removing a part of the blanket P-type layer 40 outside the gate region by etching to obtain the P-type layer 40, and forming the cap layer 50 on the P-type layer 40 in the gate region by selective region epitaxy to form the semiconductor structure as shown in FIG. 9.

At step S3: a source electrode and a drain electrode are provided on the side of the barrier layer away from the substrate, and a gate electrode is provided on the side of the cap layer away from the substrate and between the source electrode and the drain electrode.

Specifically, a source electrode 61 and a drain electrode 62 are provided on the side of the barrier layer 30 away from the substrate 10, and a gate electrode 63 is provided on the side of the cap layer 50 away from the substrate 10 and between the source electrode 61 and the drain electrode 62, to form the semiconductor structure shown in FIG. 1. The pits 51 are completely filled with a metal material of the gate electrode 63, on one hand, the contact interface between the cap layer 50 and the gate electrode 63 is replaced from the C crystal plane to the (1101) or (1122) crystal plane, thereby effectively improving the Schottky barrier height, reducing the gate leakage current, and improving the quality and the reliability of the device; and on the other hand, the gate control capability is improved.

In some embodiments, a ratio of a total projected area of the pits 51 on a plane of the substrate 10 to a projected area of the cap layer 50 on the plane of the substrate 10 is greater than 70%. The density and the size of the pits 51 are increased, that is, the area of the C crystal plane in contact with the metal of the gate electrode is reduced, thereby improving the Schottky barrier height, reducing the gate leakage current, and improving the quality and the reliability of the device.

In some embodiments, the depth of at least one of the pits 51 is different from the depths of the other pits 51. In some examples, as shown in FIG. 2, depths of the pits 51 gradually increase from a center to an edge. The current leakage issues are more prone to occur at the sidewall of the gate region in semiconductor structures. Therefore, the depths of the pits 51 at the edge are designed to be larger, thereby reducing the possibility of sidewall leakage.

In some embodiments, as shown in FIG. 3, the projection density of the pits 51 on the plane of the substrate 10 gradually increases from the center to the edge. The current leakage issues are more prone to occur at the sidewall of the gate region in semiconductor structures. Therefore, the density of the pits 51 at the edge are designed to be larger, thereby reducing the possibility of sidewall leakage.

In some examples, FIG. 12 is a schematic three-dimensional structural diagram of a cap layer of a semiconductor structure according to some embodiments of the present disclosure, and as shown in FIG. 12, the pits 51 are the hexagonal pyramid shape, and are randomly distributed on the upper surface of the cap layer 50 with varying depths and opening areas.

The present disclosure provides a semiconductor structure and a method for manufacturing thereof, and the semiconductor structure includes a substrate, a channel layer on the substrate and a barrier layer on the channel layer; a P-type layer in a gate region and on a side of the barrier layer away from the substrate; and a cap layer on the side of the P-type layer away from the substrate, where a surface of the side of the cap layer away from the substrate includes pits. The pits 51 provided in the cap layer 50 can replace the contact interface between the cap layer 50 and the gate electrode 63 from the C crystal plane to the non-C crystal plane, thereby effectively improving the Schottky barrier height, reducing the gate leakage current, and improving the quality and the reliability of the device.

It should be understood that the term "include" and variants thereof used in the present disclosure are open-ended, that is, "includes but is not limited to". The term "one embodiment" refers to "at least one embodiment"; and the term "another embodiment" refers to "at least one additional embodiment". In this specification, the illustrative use of the aforementioned terms does not necessarily refer to the same embodiment or example. Moreover, the specific features, structures, materials, or characteristics described herein may be combined in any one or more embodiments or examples in an appropriate manner. Furthermore, without mutual contradiction, those skilled in the art may combine and integrate features from different embodiments or examples described in this specification, as well as combine or merge different embodiments or examples themselves.

The above descriptions are some embodiments of the present disclosure and are not intended to limit the present disclosure, and any modifications, equivalent substitutions and the like made within the spirit and the principle of the present disclosure shall fall within the protection scope of the present disclosure.

## Claims

1. A semiconductor structure, comprising:
a substrate (10);
a channel layer (20) on the substrate (10);
a barrier layer (30) on the channel layer (20);
a P-type layer (40) in a gate region and on a side of the barrier layer (30) away from the substrate (10); and
a cap layer (50) on a side of the P-type layer (40) away from the substrate (10);
wherein a surface of the cap layer (50) away from the substrate (10) comprises pits (51), and crystal planes of inner walls of the pits (51) comprise (1101) or (1122) crystal planes.

2. The semiconductor structure according to claim 1, wherein the pits (51) comprise V-shaped pits formed by epitaxial growth, or pyramid-shaped pits or frustum-shaped pits formed by etching.

3. The semiconductor structure according to claim 1 or 2, further comprising:
an insertion layer (70) between the P-type layer (40) and the cap layer (50).

4. The semiconductor structure according to any one of claims 1-3, wherein the cap layer (50) is made of InGaN, AlInGaN, unintentionally doped GaN or n-type doped GaN.

5. The semiconductor structure according to any one of claims 1-4, wherein a ratio of a total projected area of the pits (51) on a plane of the substrate (10) to a projected area of the cap layer (50) on the plane of the substrate (10) is greater than 70%;
wherein a projection density of the pits (51) on a plane of the substrate (10) gradually increases from a center to an edge.

6. The semiconductor structure according to any one of claims 1-5, wherein a depth of at least one of the pits (51) is different from depths of other pits (51);
wherein depths of the pits (51) gradually increase from a center to an edge.

7. The semiconductor structure according to any one of claims 1-6, further comprising:
a source electrode (61) and a drain electrode (62) on a side of the barrier layer (30) away from the substrate (10); and
a gate electrode (63) on a side of the cap layer (50) away from the substrate (10) and between the source electrode (61) and the drain electrode (62);
wherein the pits (51) are completely filled with a metal material of the gate electrode (63).

8. The semiconductor structure according to claim 7, wherein a contact interface between the cap layer (50) and the gate electrode (63) is replaced from a C crystal plane to (1101) or (1122) crystal planes by providing the pits (51) in the cap layer (50).

9. The semiconductor structure according to claim 7, wherein the pits (51) comprise a first pit and a second pit which are respectively in two edge regions, the first pit is closer to the drain electrode (62) than the second pit, and a depth of the first pit is greater than a depth of the second pit.

10. The semiconductor structure according to any one of claims 1-9, wherein the pits (51) penetrate through the cap layer (50).

11. A method for manufacturing a semiconductor structure, comprising:
providing a substrate (10), a channel layer (20) and a barrier layer (30) which are sequentially stacked; and
forming a P-type layer (40) and a cap layer (50) which are in a gate region and sequentially stacked on a side of the barrier layer (30) away from the substrate (10), wherein a surface of the cap layer (50) away from the substrate (10) comprises pits (51), and crystal planes of inner walls of the pits (51) comprise (11̅01) or (112̅2) crystal planes.

12. The method according to claim 11, wherein forming the P-type layer (40) and the cap layer (50) which are in the gate region and sequentially stacked on the side of the barrier layer (30) away from the substrate (10) comprises:
growing a blanket P-type layer (40) and a blanket cap layer (50) sequentially; and
removing a part of the blanket P-type layer (40) and a part of the blanket cap layer (50) outside the gate region by etching.

13. The method according to claim 11 or 12, wherein forming the P-type layer (40) and the cap layer (50) which are in the gate region and sequentially stacked on the side of the barrier layer (30) away from the substrate (10) comprises:
growing a blanket P-type layer (40);
removing a part of the blanket P-type layer (40) outside the gate region by etching to obtain the P-type layer (40); and
forming the cap layer (50) on the P-type layer (40) in the gate region by selective epitaxy.

14. The method according to any one of claims 11-13, wherein the pits (51) comprise:
V-shaped pits formed when the cap layer (50) is epitaxially grown, wherein crystal planes of inner walls of the V-shaped pits comprise (11̅01) crystal planes; or
pyramid-shaped pits or frustum-shaped pits formed when the cap layer (50) is etched, wherein crystal planes of inner walls of the pyramid-shaped pits or the frustum-shaped pits comprise (11̅01) crystal planes or (112̅2) crystal planes.

15. The method according to any one of claims 11-14, further comprising:
providing a source electrode (61) and a drain electrode (62) on a side of the barrier layer (30) away from the substrate (10), and
providing a gate electrode (63) on a side of the cap layer (50) away from the substrate (10) and between the source electrode (61) and the drain electrode (62);
wherein the pits (51) are completely filled with a metal material of the gate electrode (63).
